# EUROPÄISCHE PATENTSCHRIFT

(11) **EP 2 052 419 B1**
(45) Veröffentlichungstag und Bekanntmachung des Hinweises auf die Patenterteilung: **07.11.2018**
(21) Anmeldenummer: 07817511.4
(22) Anmeldetag: 10.09.2007
(51) Int. Cl.: H01L 33/22, H01L 33/00, H01L 33/46, H01L 33/40

(54) **HALBLEITERCHIP UND VERFAHREN ZUR HERSTELLUNG EINES HALBLEITERCHIPS**
SEMICONDUCTOR CHIP AND METHOD FOR PRODUCING A SEMICONDUCTOR CHIP
PUCE À SEMI-CONDUCTEUR ET PROCÉDÉ POUR FABRIQUER UNE PUCE À SEMI-CONDUCTEUR

(30) Priorität: 29.09.2006 DE 102006046677; 29.01.2007 DE 102007004302
(43) Veröffentlichungstag der Anmeldung: 29.04.2009
(73) Patentinhaber: OSRAM Opto Semiconductors GmbH, 93055 Regensburg (DE)
(72) Erfinder: STRAUSS, Uwe, 93077 Bad Abbach (DE)
(74) Vertreter: Epping - Hermann - Fischer
(86) Internationale Anmeldenummer: PCT/DE2007/001638
(87) Internationale Veröffentlichungsnummer: WO 2008/040289

(56) Entgegenhaltungen:
- WO-A-2006/006555
- DE-A1- 10 027 199
- DE-A1- 10 245 628
- US-A- 3 739 217
- US-A1- 2004 119 084
- US-A1- 2005 093 008
- US-A1- 2005 104 080
- US-A1- 2005 184 297
- US-A1- 2006 001 035
- US-A1- 2006 006 402
- US-A1- 2006 054 898
- US-A1- 2006 163 595
- US-B1- 6 495 862
- US-B1- 6 657 236

## Beschreibung

Die Erfindung betrifft einen Halbleiterchip sowie ein Verfahren zur Herstellung eines Halbleiterchips.

Die Produktion von LED-Halbleiterchips mit einer hohen Auskoppeleffizienz, also einem großen Verhältnis der Zahl der aus dem Halbleiterchip ausgekoppelten Photonen zur Zahl der im Halbleiterchip erzeugten Photonen, erfordert in der Regel aufwändige Herstellungsprozesse. Eine Steigerung der Auskoppeleffizienz bei LEDs geht deshalb meist mit einer Zunahme der Herstellungskosten einher.
Es ist eine Aufgabe der vorliegenden Erfindung, einen Halbleiterchip, insbesondere einen Halbleiterchip für eine LED, anzugeben, der bei hoher Auskoppeleffizienz kostengünstig herstellbar ist. Ferner soll ein Verfahren angegeben werden, mit dem ein Halbleiterchip kostengünstig hergestellt werden kann.
Diese Aufgabe wird erfindungsgemäß durch einen Halbleiterchip mit den Merkmalen des Patentanspruchs 1 beziehungsweise ein Verfahren mit den Merkmalen des Patentanspruchs 12 gelöst. Vorteilhafte Ausgestaltungen und Weiterbildungen der Erfindung sind Gegenstand der abhängigen Patentansprüche.

Ein erfindungsgemäßer Halbleiterchip, der in Anspruch 1 definiert und bevorzugt als LED-Halbleiterchip ausgeführt ist, weist einen Träger und einen Halbleiterkörper auf. Der Halbleiterkörper umfasst eine Halbleiterschichtenfolge mit einem zur Erzeugung von Strahlung vorgesehenen aktiven Bereich. Der Träger weist eine dem Halbleiterkörper zugewandte erste Trägerfläche und eine vom Halbleiterkörper abgewandte zweite Trägerfläche auf. Weiterhin ist der Halbleiterkörper mittels einer Verbindungsschicht stoffschlüssig an dem Träger befestigt, und zwischen der zweiten Trägerfläche und dem aktiven Bereich ist eine Mehrzahl von reflektierenden oder streuenden Elementen ausgebildet.
Die mittels der Verbindungsschicht ausgebildete stoffschlüssige Verbindung zur Befestigung des Halbleiterkörpers an dem Träger ist, etwa im vergleich zu einer Befestigung mittels eutektischen Bondens, mit Vorteil vereinfacht und kostengünstig herstellbar.
Zwischen dem Halbleiterkörper und dem Träger ist mittels der Verbindungsschicht eine stoffschlüssige Verbindung hergestellt. Hierbei wird unter einer stoffschlüssigen Verbindung insbesondere eine Verbindung verstanden, bei der die Verbindungspartner zusammengefügt und aufgrund von atomaren oder molekularen Kräften zusammengehalten werden. Typische Beispiele für stoffschlüssige Verbindungen sind verbindungen, die mittels Klebens, Lötens, Schweißens oder Galvanisierens hergestellt sind. Unter einer Verbindungsschicht wird im Rahmen der Erfindung eine Schicht verstanden, die mittels eines gesonderten Verbindungsmittels gebildet ist, das an der Herstellung der stoffschlüssigen Verbindung beteiligt ist.

Eine epitaktisch abgeschiedene Schicht, etwa eine Pufferschicht, die zwischen einem Aufwachssubstrat und einem Halbleiterkörper angeordnet ist, wird dagegen nicht als eine Verbindungsschicht im Sinne der vorliegenden Erfindung angesehen.

In der erfindungsgemäßen Ausgestaltung ist die Mehrzahl von reflektierenden oder streuenden Elementen zwischen der zweiten Trägerfläche und dem Halbleiterkörper ausgebildet. Die Mehrzahl von reflektierenden oder streuenden Elementen kann somit außerhalb des Halbleiterkörpers ausgebildet sein.

In der erfindungsgemäßen Ausgestaltung ist zwischen dem Halbleiterkörper und der Verbindungsschicht eine für im aktiven Bereich erzeugte Strahlung durchlässige Kontaktschicht ausgebildet. Besonders bevorzugt enthält die Kontaktschicht ein transparentes leitfähiges Oxid (transparent conductive oxide, TCO). Transparente leitfähige Oxide sind transparente, leitfähige Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitfähiger Oxide zu der Gruppe der TCOs. Weiterhin entsprechen die TCOs nicht zwingend einer stöchiometrischen Zusammensetzung und können auch p-dotiert oder n-dotiert sein.

Eine derartige Kontaktschicht hat den Vorteil, dass diese bei hoher Querleitfähigkeit für im Halbleiterkörper erzeugte Strahlung durchlässig ausgebildet sein kann.
Eine TCO-haltige Kontaktschicht kann auf einem, insbesondere vorgefertigten, Halbleiterkörper abgeschieden, beispielsweise aufgesputtert oder aufgedampft sein.
In einer weiteren bevorzugten Ausgestaltung ist die Verbindungsschicht für im aktiven Bereich des Halbleiterkörpers erzeugte Strahlung durchlässig ausgebildet. Absorptionsverluste beim Durchtritt dieser Strahlung durch die Verbindungsschicht können auf diese Weise mit Vorteil vermindert werden.

Weiterhin ist die Kontaktschicht und bevorzugt auch die Verbindungsschicht bezüglich ihrer Brechungsindizes an den Brechungsindex des Halbleiterkörpers angepasst. Hierbei wird im Zweifel unter dem Brechungsindex des Halbleiterkörpers der gemittelte Brechungsindex der Halbleiterschichtenfolge verstanden. Je geringer die Differenz zwischen dem Brechungsindex der Verbindungsschicht beziehungsweise der Kontaktschicht und demjenigen des Halbleiterkörpers ist, desto größer ist der Anteil der in Richtung des Trägers abgestrahlten Strahlung, der aus dem Halbleiterkörper austreten und auf die Mehrzahl von reflektierenden oder streuenden Elementen auftreffen kann.
In einer weiteren bevorzugten Ausgestaltung ist die Verbindungsschicht mittels eines Verbindungsmittels gebildet. Das Verbindungsmittel ist bevorzugt als Formmasse ausgeführt. Beispielsweise kann die Verbindungsschicht eine Klebeschicht sein, die mittels eines Klebemittels gebildet ist. Eine einfache und kostengünstige Herstellung einer stoffschlüssigen Verbindung wird hierdurch erleichtert.

In einer bevorzugten Weiterbildung ist die Verbindungsschicht, beispielsweise die Klebeschicht, elektrisch isolierend ausgebildet. Der Halbleiterkörper kann so an dem Träger von diesem elektrisch isoliert befestigt sein.

Der Halbleiterchip weist bevorzugt zwei Kontakte auf, die mit dem Halbleiterkörper elektrisch leitend verbunden sind. Über diese Kontakte kann zum Betrieb des Halbleiterchips durch Anlegen einer externen elektrischen Spannung ein Strom in den Halbleiterkörper eingeprägt werden. Hierbei sind die Kontakte zweckmäßigerweise so angeordnet, dass der Strom durch den aktiven Bereich hindurchfließt. Beide Kontakte.können auf der dem Träger abgewandten Seite der Verbindungsschicht angeordnet sein. In diesem Fall können die zwischen der Kontaktschicht und der zweiten Trägerfläche angeordneten Elemente, insbesondere der Träger und die Verbindungsschicht elektrisch isolierend ausgebildet sein. In einer alternativen Variante ist einer der.Kontakte auf der zweiten Trägerfläche angeordnet. Bei dieser Variante sind die Verbindungsschicht und der Träger bevorzugt elektrisch leitfähig ausgeführt.

In einer weiteren bevorzugten Ausgestaltung ist die Verbindungsschicht derart ausgebildet, dass eine Wellenführung der im aktiven Bereich erzeugten Strahlung innerhalb der Verbindungsschicht gestört ist.

Die Wellenführung in der Verbindungsschicht kann beispielsweise dadurch verursacht werden, dass in der Verbindungsschicht verlaufende Strahlung zwischen zwei in lateraler Richtung, das heißt in einer Richtung entlang einer Haupterstreckungsrichtung der Halbleiterschichten der Halbleiterschichtenfolge, parallel zueinander verlaufenden und die Verbindungsschicht begrenzenden Flächen hin und her reflektiert wird. Hierbei weist der Winkel, in dem die Strahlung auf die Flächen auftritt, bei den aufeinander folgenden Reflexionen einen konstanten Wert auf, der oberhalb des Winkels für Totalreflexion liegt. Diese in der Verbindungsschicht umlaufende Strahlung kann somit nicht durch diese Flächen austreten und wird letztlich in der Verbindungsschicht absorbiert. Durch ein Stören der Wellenführung kann der Anteil der aus der Verbindungsschicht austretenden, und insbesondere nachfolgend durch die Strahlungsaustrittsfläche hindurch tretenden, Strahlung erhöht werden. Hierdurch wird mit Vorteil die Auskoppeleffizienz aus dem Halbleiterchip gesteigert.

In einer bevorzugten Weiterbildung ist die Mehrzahl von reflektierenden oder streuenden Elementen mittels Partikeln, die in der Verbindungsschicht ausgebildet sind, gebildet. Die Partikel können in ein Matrixmaterial für die Verbindungsschicht eingebettet sein. Die Partikel weisen bevorzugt einen Brechungsindex auf, der vom Brechungsindex des Matrixmaterials verschieden ist. Hierbei können die Partikel für im aktiven Bereich erzeugte Strahlung durchlässig oder reflektierend ausgebildet sein. Die Partikel können beispielsweise als Metallpartikel, etwa als Silberpartikel, ausgeführt sein.

Die Richtung, in die sich Strahlung in der Verbindungsschicht ausbreitet, kann aufgrund von Streuung oder Reflexion an diesen Partikel verändert werden. Dadurch kann beispielsweise Strahlung nach einer Totalreflexion an einer der die Verbindungsschicht begrenzenden Flächen derart an den Partikeln gestreut werden, dass diese nachfolgend unter einem Winkel auf eine dieser Flächen auftrifft, der kleiner ist als der Grenzwinkel für Totalreflexion. Durch die Partikel kann somit die Wellenführung in der Verbindungsschicht gestört werden. Die Auskoppeleffizienz aus dem Halbleiterchip kann so vorteilhaft gesteigert werden.

In einer bevorzugten Ausgestaltung ist zwischen dem Halbleiterkörper und dem Träger eine Spiegelschicht angeordnet. Die Spiegelschicht ist also nicht Teil des Halbleiterkörpers. Die Spiegelschicht ist zur Reflexion von im aktiven Bereich erzeugter und in Richtung des Trägers abgestrahlter Strahlung vorgesehen. Weiterhin wird durch die Spiegelschicht einer Absorption der Strahlung in dem Träger oder in einer zwischen der Spiegelschicht und dem Träger angeordneten Schicht vorgebeugt. Der Träger kann somit mit Vorteil unabhängig von den Absorptionseigenschäften für im aktiven Bereich erzeugte Strahlung gewählt werden.

Die Spiegelschicht ist bevorzugt mittels Abscheidens, beispielsweise Aufdampfens oder Sputterns, auf dem Halbleiterkörper oder auf dem Träger aufgebracht. Weiterhin enthält die Spiegelschicht bevorzugt ein Metall und ist besonders bevorzugt metallisch ausgeführt.

Der Halbleiterchip weist zweckmäßigerweise auf einer dem Träger abgewandten Seite des aktiven Bereichs eine Strahlungsaustrittsfläche auf. Durch die Spiegelschicht kann vereinfacht erreicht werden, dass die im aktiven Bereich erzeugte Strahlung überwiegend durch diese Strahlungsaustrittsfläche austritt.

In einer bevorzugten Ausgestaltung ist die Mehrzahl von reflektierenden oder streuenden Elementen mittels einer zumindest bereichsweise eine Oberflächenstruktur aufweisenden Grenzfläche gebildet. Hierbei sind die reflektierenden oder streuenden Elemente Teilbereiche der Grenzfläche, die durch die Oberflächenstruktur der Grenzfläche gebildet sind.

Bevorzugt verlaufen zumindest zwei Teilbereiche der Grenzfläche mit der Oberflächenstruktur zumindest bereichsweise schräg oder senkrecht zueinander. Mittels der Grenzfläche mit der Oberflächenstruktur kann die Wellenführung, insbesondere in einer an diese Grenzfläche angrenzenden Schicht, gestört sein. Die Auskoppeleffizienz der Strahlung aus dem Halbleiterchip kann so mit Vorteil gesteigert werden.

Die Verbindungsschicht kann an die Grenzfläche mit der Oberflächenstruktur angeformt sein. Die Wellenführung von im aktiven Bereich erzeugter Strahlung innerhalb der Verbindungsschicht kann so vorteilhaft gestört werden.

In einer bevorzugten Ausgestaltung ist die Oberflächenstruktur der Grenzfläche mittels einer strukturierten Oberfläche gebildet. Unter einer strukturierten Oberfläche wird hierbei eine Oberfläche eines Körpers, beispielsweise einer Halbleiterschicht der Halbleiterschichtenfolge, des Träger oder der Kontaktschicht, verstanden, welche Strukturelemente aufweist, die mittels teilweisen Abtragens des Körpers seitens der Oberfläche hergestellt ist. Die Strukturelemente sind bevorzugt mechanisch und/oder chemisch, beispielsweise mittels mechanischen Aufrauens, nasschemischen Ätzens, oder trockenchemischen Ätzens, etwa mittels chemisch assistierten Ionenstrahlätzens (chemical assisted ion beam etching, CAIBE) oder reaktiven Ionenätzens (reactive ion etching, RIE), hergestellt.

In einer ersten Ausführungsvariante ist die Grenzfläche mit der Oberflächenstruktur die strukturierte Oberfläche.

In einer zweiten Ausführungsvariante ist die Grenzfläche mit der Oberflächenstruktur eine dem aktiven Bereich zugewandte Fläche einer Schicht, wobei die Oberflächenstruktur der Grenzfläche der Struktur einer zumindest bereichsweise strukturierten Oberfläche folgt. Bei dieser zweiten Ausführungsvariante kann die strukturierte Oberfläche zwischen dem aktiven Bereich und der Schicht, vorzugsweise der Spiegelschicht, angeordnet sein, wobei die Schicht besonders bevorzugt an die strukturierte Oberfläche angrenzt. Hierbei ist die Schicht an die strukturierte Oberfläche angeformt, so dass die Oberflächenstruktur der Grenzfläche die Struktur der strukturierten Oberfläche nachbildet.

Alternativ kann bei der,zweiten Ausführungsvariante die strukturierte Oberfläche zwischen der Grenzfläche mit der Oberflächenstruktur und dem Träger angeordnet sein. Hierbei ist ein Abstand zwischen der Grenzfläche mit der Oberflächenstruktur und der strukturierten Oberfläche bevorzugt so gering, insbesondere ist also die Schichtdicke der Schicht, deren Oberfläche die Grenzfläche mit der Oberflächenstruktur bildet, hinreichend gering, dass die Oberflächenstruktur der Grenzfläche der Struktur der strukturierten Oberfläche folgt. Zumindest ist die Schichtdicke dieser Schicht so gering, dass ein vollständiges oder im wesentlichen vollständiges Einebnen der Struktur der strukturierten Oberfläche vermieden wird.

Bei der zweiten Ausführungsvariante ist die Schicht, deren Oberfläche die Grenzfläche mit der Oberflächenstruktur bildet, besonders bevorzugt die Spiegelschicht. Die Grenzfläche mit der Oberflächenstruktur ist also spiegelnd ausgebildet.

In einer Ausgestaltung ist die strukturierte Oberfläche zwischen dem aktiven Bereich und der Verbindungsschicht angeordnet. Bevorzugt ist die strukturierte Oberfläche die dem Träger zugewandte Fläche der Kontaktschicht. Die Wellenführung innerhalb der Kontaktschicht kann so gestört sein. Mit Vorteil kann dadurch die Auskoppeleffizienz gesteigert werden.

In einer weiteren Ausgestaltung ist die strukturierte Oberfläche zwischen der Verbindungsschicht und der zweiten Trägerfläche angeordnet. Bevorzugt ist die strukturierte Oberfläche die erste Trägerfläche des Trägers.

Selbstverständlich kann auch auf beiden Seiten der Verbindungsschicht jeweils eine strukturierte Oberfläche angeordnet sein. Beispielsweise können die erste Trägerfläche des Trägers und die dem Träger zugewandte Fläche der Kontaktschicht jeweils als eine strukturierte Oberfläche ausgebildet sein.

Die Strukturelemente der strukturierten Oberfläche können unregelmäßig angeordnet sein. Unregelmäßig angeordnete Strukturelemente, etwa Vertiefungen, sind vergleichsweise einfach herstellbar, beispielsweise mittels mechanischen Aufrauens.

Alternativ können die Strukturelemente regelmäßig, insbesondere periodisch, angeordnet sein. Auf diese Weise kann die strukturierte Oberfläche mit einer definierten Struktur, beispielsweise für ein photonisches Gitter geformt sein. Beispielsweise kann das photonische Gitter mittels eines zweidimensionalen Gitters, also mittels eines Gitters, das in zwei schräg, vorzugsweise senkrecht, zueinander verlaufenden Richtungen eine alternierende, periodisch angeordnete, Folge von Vertiefungen und Erhebungen aufweist, gebildet sein.

Sowohl regelmäßig als auch unregelmäßig angeordnete Strukturelemente können beispielsweise pyramidenartig, pyramidenstumpfartig, mikroprismenartig oder rillenartig ausgebildet sein. Weiterhin können die Strukturelemente zumindest bereichsweise gekrümmte Oberflächen aufweisen.

In einer bevorzugten Weiterbildung weisen die Strukturelemente eine laterale Ausdehnung auf, die zwischen einschließlich dem 0,1-fachen und einschließlich dem 200-fachen, besonders bevorzugt zwischen einschließlich dem 0,5-fachen und einschließlich dem 100-fachen, einer Peak-Wellenlänge der im aktiven Bereich erzeugten Strahlung im seitens des aktiven Bereichs an die Grenzfläche mit der Oberflächenstruktur angrenzenden Medium liegt. Bei einer Peak-Wellenlänge im sichtbaren Spektralbereich hat sich ein maximaler Wert für die laterale Ausdehnung von einschließlich 20 *µ*m als besonders vorteilhaft erwiesen. Bei einem photonischen Gitter ist eine Periodenlänge, also die Länge, nach der sich die Abfolge der Strukturelemente wiederholt, bevorzugt im Bereich der Peak-Wellenlänge, also etwa zwischen dem 0,5-fachen und dem fünffachen der Peak-Wellenlänge im seitens des aktiven Bereichs an die Grenzfläche mit der Oberflächenstruktur angrenzenden Medium.

In einer bevorzugten Weiterbildung ist das Aufwachssubstrat für die Halbleiterschichtenfolge entfernt oder gedünnt. Dies kann jeweils vollständig oder zumindest bereichsweise erfolgt sein.

Eine Absorption von im aktiven Bereich erzeugter Strahlung beim Austritt durch eine ursprünglich dem Aufwachssubstrat zugewandte Seite des Halbleiterkörpers aus dem Halbleiterchip kann durch Entfernen oder Abdünnen des Aufwachssubstrats mit Vorteil vermieden oder zumindest vermindert werden. Bei einem gedünnten'Aufwachssubstrat ist die verbleibende Restdicke bevorzugt hinreichend dünn, so dass im Halbleiterkörper erzeugte Strahlung nur unwesentlich beim Durchtritt durch das Aufwachssubstrat absorbiert wird.

Auch bei einem für die im aktiven Bereich erzeugte Strahlung durchlässigen Substrat ist ein Entfernen oder Dünnen des Aufwachssubstrats von Vorteil. Je dünner das verbleibende Aufwachssubstrat ist, desto stärker kann die Höhe des Halbleiterchips verringert werden. Die aus der Strahlungsaustrittsfläche des Halbleiterchips austretende Strahlungsleistung, und damit die Oberflächenleuchtdichte des Halbleiterchips, kann dadurch mit Vorteil erhöht werden. Ein vollständiges Entfernen des Aufwachssubstrats ist daher von Vorteil, ein Dünnen des Aufwachssubstrats kann aber bereits ausreichend sein.

Weiterhin können Bereiche, in denen das Aufwachssubstrat entfernt ist, der elektrischen Kontaktierung des Halbleiterkörpers, insbesondere für eine Einprägung eines Stroms in den Halbleiterkörper im Betrieb des Halbleiterchips, dienen.

Der Träger ist von dem Aufwachssubstrat für die Halbleiterschichtenfolge des Halbleiterkörpers verschieden, das heißt Abscheidung der Halbleiterschichtenfolge des Halbleiterkörpers ist nicht auf dem Träger erfolgt. Der Träger muss somit nicht die, insbesondere hinsichtlich der Kristallqualität, hohen Anforderungen an ein Aufwachssubstrat erfüllen.. Vielmehr kann der Träger hinsichtlich anderer Eigenschaften, etwa mechanischer Stabilität oder thermischer Leitfähigkeit gewählt werden. Beispielsweise kann der Träger ein Halbleitermaterial wie GaAs, Ge, GaAsP, oder Si enthalten oder aus einem solchen Halbleitermaterial bestehen. Alternativ oder ergänzend kann der Träger ein Metall, einen Kunststoff oder eine Keramik enthalten oder aus einem solchen Material bestehen.

In einer bevorzugten Ausgestaltung ist die Strahlungsaustrittsfläche des Halbleiterchips strukturiert ausgebildet. Eine Wellenführung im Halbleiterchip, insbesondere in einer Schicht, durch deren Oberfläche die Strahlungsaustrittsfläche gebildet ist, kann so mit Vorteil vermieden werden.

In einer weiteren bevorzugten Ausgestaltung ist auf der dem Träger abgewandten Seite des Halbleiterkörpers eine weitere für im Betrieb des Halbleiterchips im aktiven Bereich erzeugte Strahlung durchlässige, vorzugsweise eine TCO-Material-haltige oder aus einem solchen Material bestehende Kontaktschicht, auf dem Halbleiterkörper angeordnet. Diese weitere Kontaktschicht hat den Vorteil einer flächigen Einprägung eines Stroms in den Halbleiterkörper von der dem Träger abgewandten Seite des aktiven Bereichs. Die Strahlungsaustrittsfläche kann durch die dem Halbleiterkörper abgewandte Fläche der weiteren Kontaktschicht gebildet sein.

Das Halbleitermaterial für die Halbleiterschichtenfolge kann, beispielsweise epitaktisch, etwa mittels LPE, MBE oder MOVPE, auf einem Aufwachssubstrat abgeschieden sein.

Bevorzugt enthält der Halbleiterkörper, insbesondere der aktive Bereich ein III-V-Halbleitermaterial. Mit III-V-Halbleitermaterialien können bei der Strahlungserzeugung vorteilhaft hohe interne Quanteneffizienzen erzielt werden.

In einer weiteren bevorzugten Ausgestaltung ist der Halbleiterchip als Dünnfilm-Halbleiterchip ausgebildet. Ein Dünnfilm-Halbleiterchip, insbesondere ein Dünnfilm-Leuchtdioden-Chip, kann sich durch mindestens eines der folgenden charakteristischen Merkmale auszeichnen:
- die im aktiven Bereich der Halbleiterschichtenfolge des Halbleiterkörpers erzeugte Strahlung wird von der Spiegelschicht, die zwischen dem Halbleiterkörper und dem Träger angeordnet ist, zumindest teilweise in die Halbleiterschichtenfolge zurückreflektiert;
- die Halbleiterschichtenfolge weist eine Dicke im Bereich von 20*µ*m oder weniger, insbesondere im Bereich von 10 *µ*m auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Die Druckschrift US 2004/119084 A1 (HSIEH MIN-HSUN [TW] ET AL; 24. Juni 2004) offenbart einen Halbleiterchip gemäß dem Oberbegriff des Anpsruchs 1.

Die Druckschriften US 2005/184297 A1, US 2006/163595 A1 und WO 2006/006555 A1 beschreiben weitere Anordnungen von reflektierenden oder streuenden Elementen jeweils zwischen einer LED-Halbleiterschichtenfolge und einem Träger, mit dem diese verbunden ist.

Ein erfindungsgemäßes Verfahren zur Herstellung eines Halbleiterchips, der eine Halbleiterschichtenfolge mit einem zur Erzeugung von Strahlung vorgesehenen aktiven Bereich umfasst, ist in Anspruch 12 definiert und weist folgende Schritte auf:
a) Bereitstellen des Halbleiterkörpers mit der Halbleiterschichtenfolge, wobei auf dem Halbleiterkörper eine zur Befestigung des Halbleiterkörpersvorgesehene Befestigungsfläche angeboten wird;
b) Bereitstellen des Trägers, wobei auf dem Träger eine für die Befestigung des Halbleiterkörpers vorgesehene Montagefläche angeboten wird;
c) Ausbilden einer Verbindungsschicht zwischen der Befestigungsfläche und der Montagefläche zur Befestigung des Halbleiterkörpers an dem Träger; und
d) Fertigstellen des Halbleiterchips,
wobei zwischen der zweiten Trägerfläche und dem aktiven Bereich eine Mehrzahl von reflektierenden oder streuenden Elementen ausgebildet ist.
Mittels der Verbindungsschicht kann eine kostengünstige Befestigung des Halbleiterkörpers an dem Träger hergestellt werden.
In einer weiteren bevorzugten Ausgestaltung wird die Verbindungsschicht mittels eines Verbindungsmittels hergestellt, in dem Partikeln ausgebildet sind. Eine Wellenführung innerhalb der Verbindungsschicht kann durch Strahlumlenkung mittels der Partikel mit Vorteil gestört werden.

In einer weiteren bevorzugten Ausgestaltung wird vor Schritt c) die Befestigungsfläche als eine eine Oberflächenstruktur aufweisende Grenzfläche ausgebildet.
In einer weiteren bevorzugten Ausgestaltung wird vor Schritt c) die Montagefläche als eine eine Oberflächenstruktur aufweisende Grenzfläche ausgebildet.

Selbstverständlich können auch sowohl die Befestigungsfläche als auch die Montagefläche jeweils als eine eine Oberflächenstruktur aufweisende Grenzfläche ausgebildet sein.

Diese Oberflächenstruktur der Grenzfläche wird bevorzugt mittels einer strukturierten Oberfläche gebildet.

Die Oberfläche kann mechanisch und/oder chemisch strukturiert werden, beispielsweise mittels mechanischen Aufrauens, nasschemischen Ätzens, trockenchemischen Ätzens, etwa mittels chemisch assistierten Ionenstrahlätzens (chemical assisted ion beam etching, CAIBE) oder reaktiven Ionenätzens (reactive ion etching, RIE).

Zur Herstellung der Struktur für die strukturierte Oberfläche kann beispielsweise Lithographie, insbesondere Photolithographie oder Nano-Imprint-Lithographie, verwendet werden. Bei der Lithographie wird in der Regel auf der zu strukturierenden Fläche eine Opferschicht angeordnet. Die Opferschicht dient einer Maskierung der zu strukturierenden Oberfläche und kann nach der Lithographie, insbesondere vollständig, entfernt werden. Beispielsweise kann die Opferschicht auf der zu strukturierenden Oberfläche aufgebracht und nachfolgend strukturiert werden. Die laterale Struktur der Opferschicht kann dann, insbesondere mittels eines der oben genannten Ätzverfahren, auf die Oberfläche übertragen werden.

Bei der Photolithographie ist die Opferschicht meist eine photosensitive Lackschicht, dessen chemische Eigenschaften mittels Bestrahlung durch eine entsprechend strukturierte Maske, etwa eine Metallmaske, hindurch, lokal modifiziert werden, was ein Ausbilden der Struktur in der Opferschicht ermöglicht. Mit diesem Verfahren kann eine Strukturierung von Flächen mit Strukturgrößen von wenigen Mikrometern in lateraler Richtung erzielt werden. Sowohl regelmäßige als auch unregelmäßige Strukturen können so hergestellt werden.

Bei der Nano-Imprint-Lithographie erfolgt die Strukturierung der Opferschicht mittels eines Formwerkzeugs, das geeignet strukturiert ist. Dieses Formwerkzeug, etwa ein entsprechend strukturierter Stempel, wird in die Opferschicht eingedrückt. Die Opferschicht kann beispielsweise ein thermoplastisches Polymer (Thermoplastic Nano Imprint Lithography, T-NIL) oder ein photosensitives Material (Photo Nano Imprint Lithography, P-NIL) enthalten. Mittels Nano-Imprint-Lithographie können Oberflächen auf besonders einfache Weise strukturiert werden. Insbesondere können besonders kleine laterale Strukturgrößen, also Strukturen unterhalb von 1 µm bis in den Bereich unterhalb von 10 nm hergestellt werden. Die Nano-Imprint-Lithographie ist deshalb für die Herstellung von Strukturgrößen, die in der Größenordnung der Wellenlänge von Strahlung im infraroten, sichtbaren oder ultravioletten Spektralbereich liegen, etwa für die Herstellung von Strukturen für ein photonisches Gitter, besonders geeignet.

In einer bevorzugten Ausgestaltung wird die Grenzfläche mit der Oberflächenstruktur mittels einer Spiegelschicht gebildet, wobei die Spiegelschicht auf der zuvor strukturierten Oberfläche abgeschieden wird und die Oberflächenstruktur der Grenzfläche der Struktur dieser vorstrukturierten Oberfläche folgt. Hierbei wird die Spiegelschicht bevorzugt mittels Sputterns oder Aufdampfens auf der strukturierten Oberfläche abgeschieden. Eine spiegelnde Fläche wird somit mittels Abscheidens einer spiegelnden Schicht auf einer vorstrukturierten Fläche hergestellt. Auf ein aufwändiges Strukturieren einer spiegelnden Fläche, beispielsweise einer Metallfläche, kann mit Vorteil verzichtet werden.

In einer bevorzugten Weiterbildung wird das Aufwachssubstrat für die Halbleiterschichtenfolge entfernt oder gedünnt. Dies kann vollständig oder bereichsweise erfolgen. Hierfür kann beispielsweise eine Methode wie Schleifen, Ätzen oder ein Lasertrennverfahren eingesetzt werden. In Schritt a) kann der Halbleiterkörper mit der Halbleiterschichtenfolge auf dem Aufwachssubstrat bereitgestellt werden. In diesem Fall wird das Aufwachssubstrat bevorzugt nach Schritt c) entfernt oder gedünnt.

Davon abweichend kann das Aufwachssubstrat auch vor Schritt c) entfernt oder gedünnt werden. In diesem Fall wird der Halbleiterkörper mit der Halbleiterschichtenfolge bevorzugt zunächst auf einem Hilfsträger befestigt. Dieser Hilfsträger kann der mechanischen Stabilisierung des Halbleiterkörpers dienen und nach Schritt c) wieder entfernt werden. Auf diese Weise kann auch ein Halbleiterchip hergestellt werden, bei dem eine Fläche des Halbleiterkörpers dem Träger zugewandt ist, die ursprünglich dem Aufwachssubstrat zugewandt war.

Das beschriebene Verfahren ist zur Herstellung eines erfindungsgemäßen Halbleiterchips besonders geeignet.

Weitere Merkmale, vorteilhafte Ausgestaltungen und Zweckmäßigkeiten der Erfindung ergeben sich aus der folgenden Beschreibung der Ausführungsbeispiele in Verbindung mit den Figuren.

Es zeigen:
Figur 1 eine schematische Schnittansicht eines ersten Ausführungsbeispiels eines erfindungsgemäßen Halbleiterchips,
Figur 2 eine schematische Schnittansicht eines zweiten Ausführungsbeispiels eines erfindungsgemäßen Halbleiterchips,
Figur 3, eine schematische Schnittansicht eines dritten Ausführungsbeispiels eines erfindungsgemäßen Halbleiterchips,
Figur 4, eine schematische Schnittansicht eines vierten Ausführungsbeispiels eines erfindungsgemäßen Halbleiterchips,
Figur 5, eine schematische Schnittansicht eines fünften Ausführungsbeispiels eines erfindungsgemäßen Halbleiterchips,
Figur 6, eine schematische Schnittansicht eines sechsten Ausführungsbeispiels eines erfindungsgemäßen Halbleiterchips,
Figur 7 eine schematische Schnittansicht eines siebten Ausführungsbeispiels eines erfindungsgemäßen Halbleiterchips, und
die Figuren 8A bis 8C ein Ausführungsbeispiel für ein erfindungsgemäßes Herstellungsverfahren anhand in schematischer Schnittansicht gezeigter Zwischenschritte.

Diese Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

Gleiche, gleichartige und gleich wirkende Elemente sind in den Figuren mit gleichen Bezugszeichen versehen.

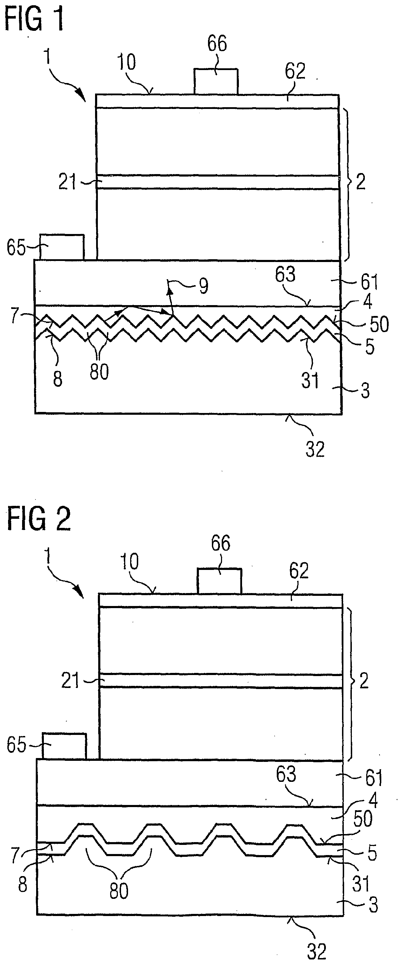

In dem in Figur 1 schematisch dargestellten ersten Ausführungsbeispiel für einen erfindungsgemäßen Halbleiterchip umfasst der Halbleiterchip 1 einen Halbleiterkörper 2 mit einer Halbleiterschichtenfolge, die einen zur Erzeugung von Strahlung vorgesehenen aktiven Bereich 21 aufweist. Der Halbleiterchip 2 ist bevorzugt als LED-Chip ausgeführt und zur Erzeugung von inkohärenter Strahlung vorgesehen. Der Halbleiterkörper 2 ist an einem Träger 3 mittels einer Verbindungsschicht 4 Stoffschlüssig befestigt. Der Träger 3 weist eine dem Halbleiterkörper zugewandte erste Trägerfläche 31 und einem vom Halbleiterkörper abgewandte zweite Trägerfläche 32 auf.

Bevorzugt ist die Verbindungsschicht 4 mittels einer Formmasse gebildet. Beispielsweise kann die Verbindungsschicht eine Klebeschicht sein. Die Formmasse kann vor dem Zusammenfügen des Halbleiterkörpers 2 und des Trägers 3 beispielsweise auf den Träger aufgebracht sein. Mittels der stoffschlüssigen Verbindung kann der Halbleiterkörper vereinfacht an dem Träger befestigt werden.

Zwischen dem Halbleiterkörper 2 und dem Träger 3 ist eine Kontaktschicht 61 mit einer dem Halbleiterkörper abgewandten Kontaktfläche 63 ausgebildet, die für im aktiven Bereich erzeugte Strahlung durchlässig ist. Bevorzugt enthält die Kontaktschicht ein TCO-Material, beispielsweise ein binäres Metalloxid, wie Zinkoxid, Zinnoxid, Cadmiumoxid, Titanoxid, Indiumoxid oder Indiumzinnoxid (ITO). Auch ternäre oder quaternäre Metalloxide können Anwendung finden.

Die Kontaktschicht 61 ist mit einem Kontakt 65 elektrisch leitend verbunden. Eine weitere Kontaktschicht 62 ist auf der dem Träger abgewandten Seite des aktiven Bereichs 21 angeordnet. Diese weitere Kontaktschicht ist mit einem weiteren Kontakt 66 elektrisch leitend verbunden und kann ebenfalls ein TCO-Material enthalten. Die Kontaktschichten 61 und 62 können beispielsweise mittels Sputterns oder Aufdampfens auf den Halbleiterkörper 2 abgeschieden sein.

Mittels der Kontaktschichten 61 und 62 kann im Betrieb des Halbleiterkörpers eine flächige Einprägung eines Betriebsstroms in den Halbleiterkörper und insbesondere in den aktiven Bereich erzielt werden, wobei die Kontaktschichten gleichzeitig für die im aktiven Bereich 21 erzeugte Strahlung durchlässig ausgeführt sein können.. Diese außerhalb des Halbleiterkörpers 2 angeordneten Kontaktschichten sind insbesondere aufgrund ihrer hohen Querleitfähigkeit vorteilhaft. Sie sind aber nicht zwingend erforderlich. Beispielsweise können alternativ, insbesondere hochdotierte, Halbleiterschichten im Halbleiterkörper zur elektrischen Kontaktierung vorgesehen sein.

Die Kontakte 65 und 66 sind zur Einspeisung von Ladungsträgern im Betrieb des Halbleiterchips in den Halbleiterkörper vorgesehen. Diese Ladungsträger können in den aktiven Bereich gelangen und dort unter Emission von elektromagnetischer Strahlung rekombinieren. Die hohe Querleitfähigkeit der Kontaktschicht 61 hat den Vorteil, dass die über den Kontakt 65 eingespeisten Ladungsträger dem Halbleiterkörper 2 in lateraler Richtung vergleichsweise gleichmäßig zugeführt werden können.

Beide Kontakte sind auf der dem Träger 3 abgewandten Seite der Verbindungsschicht 4 angeordnet. Eine Kontaktierung seitens der zweiten Trägerfläche 32 erfolgt nicht. Zwischen der Kontaktschicht 61 und der zweiten Trägerfläche 32 angeordnete Elemente, insbesondere die Verbindungsschicht 4 und der Träger 3, müssen deshalb nicht elektrisch leitfähig ausgebildet sein.

Die Kontakte 65 und 66 enthalten zweckmäßigerweise ein Metall oder eine metallische Legierung. Beispielsweise können die Kontakte Au, Ag, Ni, Pt, Cu, Ti, Al oder eine Legierung mit zumindest einem der Materialien enthalten oder aus einem solchen Material bestehen. Die Kontakte 65 und 66 können zum Beispiel mittels Sputterns oder Aufdampfens hergestellt sein.

Die dem Halbleiterkörper 2 zugewandte erste Trägerfläche des Trägers 31 ist als eine strukturierte Oberfläche 8 ausgebildet. Die strukturierte Oberfläche 8 weist periodisch angeordnete Strukturelemente 80 auf, die pyramidenartig ausgebildet sind. Die Strukturelemente weisen also zueinander schräg gestellte Seitenflächen auf, die insbesondere quer zu einer Haupterstreckungsrichtung der Halbleiterschichten der Halbleiterschichtenfolge des Halbleiterkörpers 2 verlaufen. Alternativ können die Strukturelemente beispielsweise rillenartig, etwa mit einem dreieckartigen Querschnitt, ausgebildet sein.

Abweichend von dem gezeigten Beispiel kann die strukturierte Oberfläche 8 auch unregelmäßig angeordnete Strukturelemente aufweisen. Weiterhin kann die strukturierte Oberfläche 8 auch nur bereichsweise strukturiert sein.

Die Strukturelemente 80 weisen bevorzugt eine laterale Ausdehnung auf, die zwischen einschließlich dem 0,1-fachen und einschließlich dem 200-fachen, besonders bevorzugt zwischen einschließlich dem 0,5-fachen und einschließlich dem 100-fachen, einer Peak-Wellenlänge der im aktiven Bereich 21 erzeugten Strahlung im seitens des aktiven Bereichs an die Grenzfläche 7 mit der Oberflächenstruktur angrenzenden Medium liegt. Bei einer Peak-Wellenlänge im sichtbaren Spektralbereich hat sich ein maximaler Wert für die laterale Ausdehnung von bis zu einschließlich 20 µm als besonders vorteilhaft erwiesen.

Die Strukturelemente können mechanisch und/oder chemisch, beispielsweise mittels mechanischen Aufrauens, nasschemischen Ätzens, oder trockenchemischen Ätzens, etwa mittels chemisch assistierten Ionenstrahlätzens (chemical assisted ion beam etching, CAIBE) oder reaktiven Ionenätzens (reactive ion etching, RIE) hergestellt sein.

Auf der dem Halbleiterkörper 2 zugewandten ersten Trägerfläche 31 des Trägers 3 ist eine Spiegelschicht 5 angeordnet. Diese Spiegelschicht 5 dient der Reflexion von Strahlung, die im aktiven Bereich 21 erzeugt und in Richtung des Trägers abgestrahlt wird. Die Spiegelschicht 5 enthält bevorzugt ein Metall und ist besonders bevorzugt metallisch ausgeführt. Beispielsweise kann die Spiegelschicht Al, Ag, Au, Ni, Cu oder Pt enthalten. Au beispielsweise zeichnet sich durch eine hohe Reflektivität im gelben, roten und infraroten Spektralbereich aus. Al weist im ultravioletten und im sichtbaren Spektralbereich eine hohe Reflektivität auf. Die Spiegelschicht ist bevorzugt, beispielsweise mittels Sputterns oder Aufdampfens, auf der vorstrukturierten ersten Trägerfläche 31 des Trägers 3 abgeschieden.

Eine dem aktiven Bereich 21 zugewandte Fläche 50 der Spiegelschicht 5 bildet eine Grenzfläche 7 mit einer Oberflächenstruktur. Hierbei folgt die Oberflächenstruktur der Grenzfläche der Struktur der ersten Trägerfläche 31, welche die strukturierte Oberfläche 8 bildet. Die Schichtdicke der Spiegelschicht 5 ist zweckmäßigerweise hinreichend dünn, dass die Struktur der strukturierten Oberfläche 8, also der Trägerfläche 31, nicht oder nicht wesentlich eingeebnet wird. Bevorzugt bildet die Oberflächenstruktur der Grenzfläche 7 die Struktur der strukturierten Trägerfläche 31 möglichst genau nach.

Die mittels der Oberflächenstruktur der Grenzfläche 7 gebildeten Teilbereiche der Grenzfläche stellen jeweils reflektierende Elemente für im aktiven Bereich 21 erzeugte Strahlung dar.

Die Verbindungsschicht 4 ist zweckmäßigerweise für im aktiven Bereich erzeugte Strahlung durchlässig ausgebildet. So kann im aktiven Bereich erzeugte und in Richtung des Trägers 3 abgestrahlte Strahlung nach Reflexion an der Spiegelschicht 5 durch die Strahlungsaustrittsfläche 10 aus dem Halbleiterchip 1 austreten.

Weiterhin können die Verbindungsschicht 4 und/oder die Kontaktschicht 61 bezüglich ihrer Brechungsindizes an den Brechungsindex des Halbleiterkörpers angepasst sein. Durch einen an den vergleichsweise hohen Brechungsindex des Halbleiterkörpers angepassten Brechungsindex der Verbindungsschicht beziehungsweise der Kontaktschicht kann der in Richtung des Trägers abgestrahlte Strahlungsanteil gesteigert werden, der auf die Grenzfläche mit der Oberflächenstruktur auftrifft.

Die Verbindungsschicht 4 ist an die Grenzfläche mit der Oberflächenstruktur 7 angeformt. Die der Grenzfläche mit der Oberflächenstruktur 7 zugewandte Fläche der Verbindungsschicht weist somit ebenfalls diese Oberflächenstruktur auf.

Die Wirkung der Oberflächenstruktur der Grenzfläche 7 auf Strahlung, die in der Verbindungsschicht 4 verläuft, ist anhand eines Pfeils 9 veranschaulicht. Die Strahlung trifft zunächst unter einem Winkel, der oberhalb des Grenzwinkels für Totalreflexion liegt, auf die dem Träger 3 zugewandte Oberfläche 63 der Kontaktschicht 61 und wird an dieser Oberfläche reflektiert. Nachfolgend trifft die Strahlung auf die Grenzfläche 7 mit der Oberflächenstruktur. Von dieser wird die Strahlung derart in die Verbindungsschicht 4 zurückreflektiert, dass die Strahlung nachfolgend in einem Winkel auf die Oberfläche 63 der Kontaktschicht trifft, der unterhalb des Grenzwinkels für Totalreflexion liegt. In der Folge kann die durch den Pfeil 9 dargestellte Strahlung aus der Verbindungsschicht austreten. Eine Wellenführung von Strahlung in der Verbindungsschicht 4 kann also gestört sein. Die aus einer auf der dem Träger 3 abgewandten Seite des aktiven Bereichs ausgebildeten Strahlungsaustrittsfläche 10 des Halbleiterchips 1 austretende Strahlungsleistung kann dadurch mit Vorteil gesteigert werden.

Weiterhin kann die Verbindungsschicht 4 elektrisch isolierend ausgebildet sein. Der Halbleiterchip 2 kann somit elektrisch isoliert vom Träger 3 an diesem befestigt sein.

Bevorzugt enthält der Halbleiterkörper 2, insbesondere der aktive Bereich 21 ein III-V-Halbleitermaterial. III-V-Halbleitermaterialien sind zur Strahlungserzeugung im ultravioletten (InₓGa_{y}Al_{1-x-y}N) über den sichtbaren (InₓGa_{y}Al_{1-x-y}N, insbesondere für blaue bis grüne Strahlung, oder InₓGa_{y}Al_{1-x-y}P, insbesondere für gelbe bis rote Strahlung) bis in den infraroten (InₓGa_{y}Al_{1-x-y}As) Spektralbereich besonders geeignet. Hierbei gilt jeweils 0 ≤ x ≤ 1, 0 ≤ y s 1 und x + y ≤ 1, bevorzugt mit x ≠ 0, y ≠ 0, x ≠ 1 und y ≠ 1. Weiterhin zeichnen sich, insbesondere die genannten, III-V-Halbleitermaterialien durch hohe erzielbare Quanteneffizienzen aus.

Der Halbleiterchip 1 ist als Dünnfilm-Hälbleiterchip ausgeführt. Das Aufwachssubstrat für die Halbleiterschichtenfolge des Halbleiterkörpers 2 ist vollständig entfernt und deshalb in Figur 1 nicht dargestellt. Durch das Entfernen des Aufwachssubstrats kann vermieden werden, dass Strahlung seitlich aus dem Aufwachssubstrat austritt. Die aus der Strahlungsaustrittsfläche 10 austretende Strahlungsleistung kann so mit Vorteil gesteigert werden. Weiterhin kann vermieden werden, dass Strahlung in dem Aufwachssubstrat absorbiert wird.

Der Träger 3 ist nicht mit dem Aufwachssubstrat identisch und muss nicht die, insbesondere hinsichtlich der kristallinen Reinheit, hohen Anforderungen an ein Aufwachssubstrat erfüllen. Stattdessen kann der Träger 3 nach anderen Kriterien, beispielsweise Wärmeleitfähigkeit oder mechanischer Stabilität oder Strukturierbarkeit gewählt werden. Bevorzugt enthält der Träger 3 ein Halbleitermaterial, beispielsweise Si, GaAs, Ge oder SiC oder besteht aus einem solchen Material. Ein Halbleitermaterial, insbesondere Si, ist besonders geeignet, da sich dieses typischerweise durch eine sehr gute Strukturierbarkeit, beispielsweise mittels Ätzens, auszeichnet. Si ist zudem ein vergleichsweise kostengünstiges Halbleitermaterial.

Alternativ oder ergänzend kann der Träger ein Metall, etwa Cu, eine Keramik oder einen Kunststoff enthalten oder aus einem solchen Material bestehen.

In Figur 2 ist ein zweites Ausführungsbeispiel für einen erfindungsgemäßen Halbleiterchip 1 gezeigt. Dieses zweite Ausführungsbeispiel entspricht im Wesentlichen dem ersten Ausführungsbeispiel. Davon abweichend weist die strukturierte Oberfläche 8, die wie im ersten Ausführungsbeispiel die erste Trägerfläche 31 des Trägers 3 ist, Strukturelemente 80 in Form von Erhebungen auf, die pyramidenstumpfartig verlaufen. Solche Erhebungen können beispielsweise mittels nasschemischen Ätzens des ursprünglich zwischen den Erhebungen befindlichen Trägermaterials hergestellt sein.

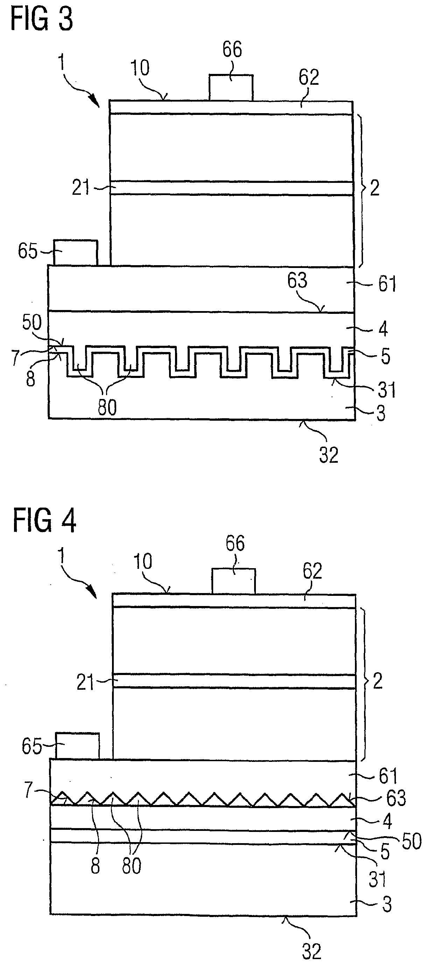

In Figur 3 ist ein drittes Ausführungsbeispiel für einen erfindungsgemäßen Halbleiterchip 1 gezeigt. Dieses dritte Ausführungsbeispiel entspricht im Wesentlichen dem ersten Ausführungsbeispiel. Davon abweichend ist strukturierte Oberfläche 8 für ein photonisches Gitter geformt. In der Oberfläche sind grabenartige Vertiefungen ausgebildet, die periodisch angeordnet sind. Bevorzugt ist das Gitter als zweidimensionales Gitter ausgebildet, es kann also entlang zwei, besonders bevorzugt zueinander senkrecht verlaufenden Richtungen, eine periodische Struktur aufweisen. Die Periodenlänge liegt bevorzugt im Bereich der Peak-Wellenlänge der im aktiven Bereich 21 erzeugten Strahlung im an die Grenzfläche 7 mit der Oberflächenstruktur angrenzenden Medium, also der Verbindungsschicht 5. Die Grenzfläche 7 mit der Oberflächenstruktur, die wie im ersten Ausführungsbeispiel durch die dem aktiven Bereich zugewandte Oberfläche der Spiegelschicht 50 gebildet ist, stellt in diesem Fall ein reflektierendes Beugungsgitter dar.

Alternativ zu den im Zusammenhang mit den Figuren 1 bis 3 beschriebenen Ausführungsbeispielen kann die Grenzfläche 7 mit der Oberflächenstruktur die strukturierte Oberfläche, also etwa die erste Trägerfläche 31, sein. In diesem Fall kann auf die Spiegelschicht 7 verzichtet werden. Dies kann insbesondere zweckmäßig sein, wenn der Träger 3 hinreichend reflektierend ausgebildet ist. Zum Beispiel kann der Träger als freitragender Metallträger ausgebildet sein.

Eine Strukturierung des Trägers 3 oder einer darauf aufgebrachten Schicht, hat den Vorteil, dass die erzeugte Struktur, etwa hinsichtlich ihrer optischen Eigenschaften, getestet werden kann, bevor der Halbleiterkörper 2 an dem Träger 3 befestigt wird. Weiterhin muss mit Vorteil der Halbleiterkörper 2 nicht strukturiert werden. Die Gefahr einer Schädigung des, im Vergleich zum Träger 3 kostenintensiv hergestellten, Halbleiterkörpers während der Strukturierung kann so vermieden werden.

In Figur 4 ist ein viertes Ausführungsbeispiel für einen erfindungsgemäßen Halbleiterchip 1 gezeigt. Dieses vierte Ausführungsbeispiel entspricht im Wesentlichen dem ersten Ausführungsbeispiel. Davon abweichend ist die Grenzfläche 7 mit der Oberflächenstruktur die dem Träger 3 zugewandte Fläche 63 der Kontaktschicht 61. Somit ist die Grenzfläche mit der Oberflächenstruktur zwischen dem Halbleiterkörper 2 und der Verbindungsschicht 4 ausgebildet. Hierbei kann die Struktur wie im Zusammenhang mit den Figuren 1 bis 3 beschrieben ausgebildet sein.

Die Verbindungsschicht 4 grenzt wiederum an die Grenzfläche 7 mit der Oberflächenstruktur an und ist an diese angeformt. Eine Wellenführung von in der Verbindungsschicht verlaufender Strahlung kann durch diese Grenzfläche mit Vorteil gestört werden. Weiterhin kann auch eine Wellenführung von innerhalb der Kontaktschicht 61 verlaufender Strahlung gestört werden. Die Auskoppeleffizienz von im aktiven Bereich 21 erzeugter Strahlung aus dem Halbleiterchip 1 kann so mit Vorteil gesteigert werden.

Auf eine Strukturierung einer zwischen der Verbindungsschicht 4 und der zweiten Trägerfläche 32 angeordneten Fläche, etwa der ersten Trägerfläche 31, zur Störung der Wellenführung in der Verbindungsschicht 4 kann in diesem vierten Ausführungsbeispiel verzichtet werden. Eine solche Strukturierung kann aber zusätzlich ausgebildet sein.

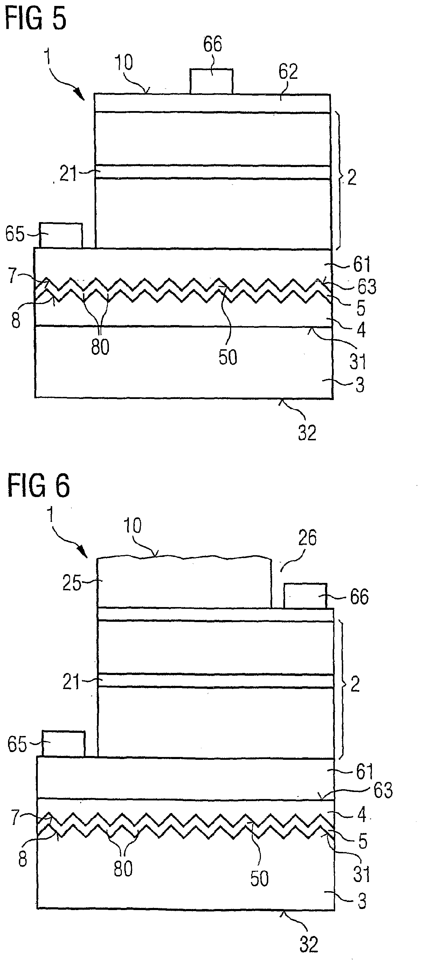

In Figur 5 ist ein fünftes Ausführungsbeispiel für einen erfindungsgemäßen Halbleiterchip 1 gezeigt. Dieses fünfte Ausführungsbeispiel entspricht im Wesentlichen dem vierten Ausführungsbeispiel. Im Unterschied dazu ist die Spiegelschicht 5 zwischen dem aktiven Bereich 21 und der Verbindungsschicht 4 angeordnet. Hierbei ist die Grenzfläche 7 mit der Oberflächenstruktur die dem aktiven Bereich 21 zugewandte Oberfläche 50 der Spiegelschicht 5, wobei die Spiegelschicht an die dem Träger zugewandten Oberfläche 63 der Kontaktschicht 61 angrenzt und an diese angeformt ist. Die dem Träger zugewandte Oberfläche 63 der Kontaktschicht 61 ist in diesem Ausführungsbeispiel die strukturierte Oberfläche 8.

Die Oberflächenstruktur der Grenzfläche 7, also die dem aktiven Bereich 21 zugewandte Oberfläche 50 der Spiegelschicht 5, folgt der Struktur der strukturierten Oberfläche 8. Im aktiven Bereich 21 erzeugte und in Richtung des Trägers abgestrahlte Strahlung wird von der Spiegelschicht 5 reflektiert. Zweckmäßigerweise ist die Spiegelschicht für diese Strahlung nicht oder nur geringfügig durchlässig, so dass die Strahlung nicht in die Verbindungsschicht 4 eintritt.

Die Verbindungsschicht 4 kann deshalb unabhängig von seinen optischen Eigenschaften gewählt werden. Beispielsweise kann die Verbindungsschicht für im aktiven Bereich erzeugte Strahlung absorbierend ausgebildet sein. Insbesondere kann die Verbindungsschicht auch als die Strahlung absorbierende Klebeschicht oder als Lotschicht ausgebildet sein.

Ein sechstes Ausführungsbeispiel für einen erfindungsgemäßen Halbleiterchip 1 ist in Figur 6 dargestellt. Dieses sechste Ausführungsbeispiel entspricht im Wesentlichen dem ersten Ausführungsbeispiel. Im Unterschied dazu ist das Aufwachssubstrat 25 für die Halbleiterschichtenfolge des Halbleiterkörpers 2 nur bereichsweise entfernt. Hierbei kann das Aufwachssubstrat gedünnt sein. Zudem ist auf die weitere Kontaktschicht 62 verzichtet.

Das Aufwachssubstrat 25 weist eine Aussparung 26 auf. Im Bereich der Aussparung ist der Halbleiterkörper 2 freigelegt. In dieser Aussparung ist der weitere Kontakt 66 angeordnet. Der weitere Kontakt grenzt direkt an den Halbleiterkörper 2 an. Die dem aktiven Bereich abgewandte Fläche des Aufwachssubstrats 25 bildet die Strahlungsaustrittsfläche 10 des Halbleiterchips 1.

Abweichend von diesem Ausführungsbeispiel kann auf die Aussparung 26 verzichtet werden. Dies kann insbesondere zweckmäßig sein, wenn das Aufwachssubstrat, etwa aufgrund einer geeigneten Dotierung, eine hinreichend hohe Leitfähigkeit aufweist. In diesem Fall kann der weitere Kontakt 66.auf der dem aktiven Bereich abgewandten Fläche des Aufwachssubstrats 25 gebildet sein. Das Aufwachssubstrat 25 kann auch bei dieser Variante vollständig oder bereichsweise gedünnt sein. Je dünner das Aufwachssubstrat ist, umso geringer ist die aus den das Aufwachssubstrat in lateraler Richtung begrenzenden Seitenflächen austretende Strahlungsleistung. Die aus der Strahlungsaustrittsfläche 10 des Halbleiterchips 1 austretende Strahlungsleistung kann so mit Vorteil gesteigert werden.

Die Strahlungsaustrittsfläche 10 des Halbleiterchips ist strukturiert ausgebildet. Mittels der Strukturierung kann die Wellenführung in dem die Strahlungsaustrittsfläche bildenden Element, beispielsweise in dem Aufwachssubstrat, gestört werden. Im gezeigten Beispiel ist die Strukturierung der Strahlungsaustrittsfläche unregelmäßig. Davon abweichend kann die Strahlungsaustrittsfläche auf die gleiche Weise strukturiert sein, wie dies im Zusammenhang mit den Figuren 1 bis 3 für die Strukturierung der strukturierten Oberfläche beschrieben ist.

Eine Strukturierung der Strahlungsaustrittsfläche ist selbstverständlich auch in den weiteren Ausführungsbeispielen, die im Zusammenhang mit den Figuren 1 bis 5 und der Figur 7 beschrieben sind, möglich.

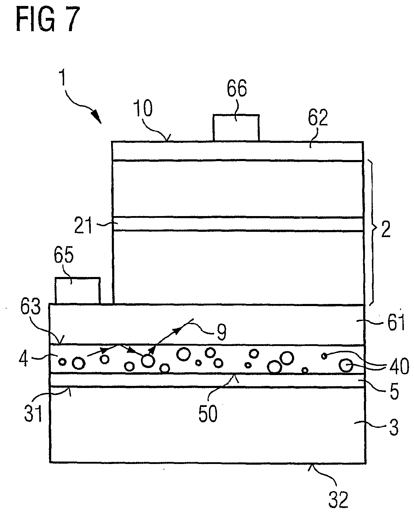

Ein siebtes Ausführungsbeispiel für einen erfindungsgemäßen Halbleiterchip 1 ist in Figur 7 dargestellt. Dieses siebte Ausführungsbeispiel entspricht im Wesentlichen dem ersten Ausführungsbeispiel. Im Unterschied zum ersten Ausführungsbeispiel sind die reflektierenden oder streuenden Elemente mittels Partikeln 40 gebildet, die in der Verbindungsschicht 4 ausgebildet sind. Beispielsweise kann die Verbindungsschicht 4 mittels einer Formmasse gebildet sein, in die die Partikel eingebettet sind. Die Partikel 40 können beispielsweise Metallpartikel, etwa Ag-Partikel sein. Weiterhin können die Partikel zumindest teilweise unterschiedliche Größen aufweisen. Im aktiven Bereich erzeugte und in der Verbindungsschicht verlaufende Strahlung kann an diesen Partikeln gestreut oder reflektiert werden. Wie durch den Pfeil 9 veranschaulicht, kann eine Reflexion oder Streuung an den Partikel eine Änderung der Richtung, in der sich die Strahlung in der Verbindungsschicht 4 ausbreitet, bewirken. Eine Wellenführung in der Verbindungsschicht kann dadurch gestört sein.

Die Partikel 40 können auch für die im aktiven Bereich 21 strahlungsdurchlässig ausgebildet sein. Auch in diesem Fall können die Partikel Änderung der Richtung, in der sich Strahlung in der Verbindungsschicht 4 ausbreitet, bewirken, etwa auch beim Durchtritt durch die Partikel aufgrund von Brechung oder durch Streuung an den Partikeln.

Eine Grenzfläche 7 mit einer Oberflächenstruktur, wie sie im Zusammenhang mit den Figuren 1 bis 3 beschrieben ist, ist bei diesem Ausführungsbeispiel für die Störung der Wellenführung nicht notwendig, kann aber selbstverständlich zusätzlich Verwendung finden. Insbesondere kann bei der Herstellung des Halbleiterchips 1 auf eine Strukturierung des Halbleiterkörpers 2 verzichtet werden.

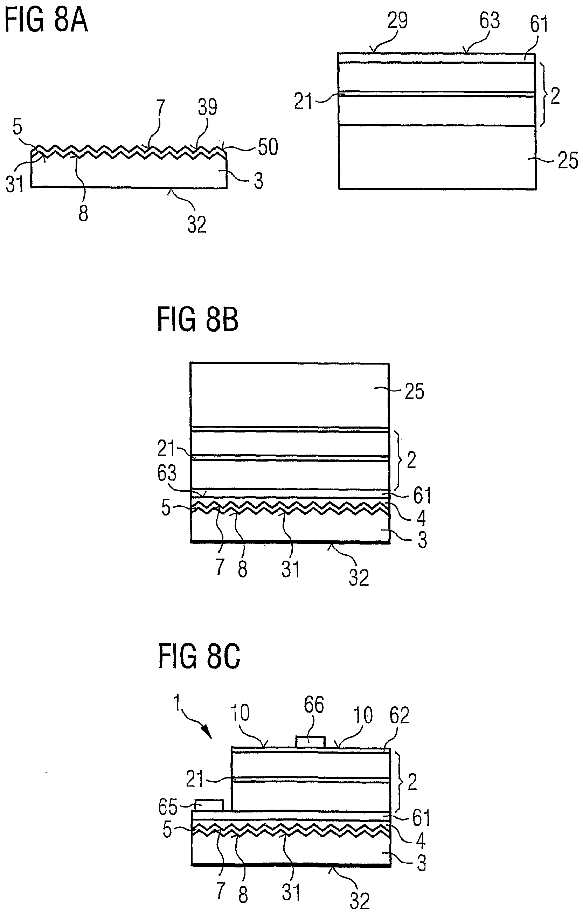

Ein Ausführungsbeispiel für ein erfindungsgemäßes Verfahren zur Herstellung eines Halbleiterchips ist in den Figuren 8A bis 8C anhand von Zwischenschritten schematisch dargestellt. In diesem Ausführungsbeispiel ist exemplarisch die Herstellung eines Halbleiterchips dargestellt, der wie im Zusammenhang mit Figur 1 beschrieben ausgebildet ist. Selbstverständlich ist das Verfahren auch für die Herstellung von davon abweichend aufgebauten Halbleiterchips 1, insbesondere für Halbleiterchips, wie sie im Zusammenhang mit den Figuren 1 bis 7 erläutert sind, geeignet.

In Figur 8A ist ein Träger 3 gezeigt, der eine erste Trägerfläche 31 und eine zweite Trägerfläche 32 aufweist. Diese erste Trägerfläche ist als strukturierte Oberfläche 8 ausgebildet. Auf dieser ersten Trägerfläche 31 ist eine Spiegelschicht 5 angeordnet. Die dem Träger abgewandte Oberfläche 50 der Spiegelschicht 5 stellt eine Montagefläche 39 dar, die für die Montage des Halbleiterkörpers 2 an dem Träger 3 angeboten wird. Die Montagefläche ist als eine eine Oberflächenstruktur aufweisende Grenzfläche 7 ausgebildet. Die Oberflächenstruktur der Grenzfläche 7 folgt der Struktur der strukturierten Oberfläche, also der ersten Trägerfläche 31 des Trägers 3.

Bevorzugt wird die Struktur der strukturierten Oberfläche mechanisch und/oder chemisch beispielsweise mittels mechanischen Aufrauens oder Rücksputterns oder mittels Ätzens hergestellt. Beispielsweise eignen sich nasschemisches Ätzen oder trockenchemisches Ätzen, etwa chemisch assistierten Ionenstrahlätzen (chemical assisted ion beam etching, CAIBE), reaktives Ionenätzen (reactive ion etching, RIE) oder Ionenstrahlätzen hergestellt.

Weiterhin können für die Herstellung der Struktur lithographische Methoden, insbesondere Photolithographie oder Nano-Imprint-Lithographie, verwendet werden, wobei bevorzugt zunächst eine Opferschicht auf die zu strukturierende Oberfläche aufgebracht und entsprechend strukturiert wird. Nachfolgend wird das Grundmuster der lateralen Struktur der Opferschicht mittels eines der genannten Ätzverfahren auf die zu strukturierende Oberfläche übertragen.

Insbesondere eine Oberflächenstruktur für ein photonisches Gitter, die im Zusammenhang mit Figur 3 beschrieben ist, wird bevorzugt mittels Nano-Imprint-Lithographie hergestellt. Das Formwerkzeug kann beispielsweise ein Quarzglas enthalten oder aus einem Quarzglas bestehen.

Die Opferschicht kann einen Thermoplasten enthalten, der nach dem Eindrücken des Formwerkzeugs in die Opferschicht durch Erhitzen gehärtet wird. Alternativ kann die Opferschicht ein photosensitives Material enthalten, bei dem das Härten nach dem Eindrücken des Formwerkzeugs beispielsweise durch Bestrahlung mittels hochenergetischer Strahlung, etwa ultravioletter Strahlung, erfolgt.

Durch die Nano-Imprint-Lithographie können auch besonders kleine laterale Strukturgrößen, also Strukturen unterhalb von 1 *µ*m bis in den Bereich unterhalb von 10 nm hergestellt werden. Die Nano-Imprint-Lithographie ist deshalb für die Herstellung von Strukturgrößen, die in der Größenordnung der Peak-Wellenlänge von im aktiven Bereich 21 erzeugter Strahlung, die vorzugsweise im infraroten, sichtbaren oder ultravioletten Spektralbereich liegt, etwa für die Herstellung von Strukturen für ein photonisches Gitter, besonders geeignet. Für die Übertragung von solch kleinen Strukturen der Oberschicht in die zu strukturierende Oberfläche sind trockenchemische Ätzverfahren, etwa CAIBE oder RIE besonders vorteilhaft.

Für die Montage des Halbleiterkörpers 2 wird eine vorstrukturierte Montagefläche 39 angeboten. Die Struktur der Montagefläche kann mit Vorteil bereits vor dem Befestigen des Halbleiterkörpers, beispielsweise hinsichtlich ihrer optischen Eigenschaften getestet werden. Weiterhin kann mit Vorteil auf eine Strukturierung des Halbleiterkörpers verzichtet werden. Die Gefahr einer Schädigung des Halbleiterkörpers 2 während der Strukturierung kann mit Vorteil vermieden werden.

Ferner wird ein Halbleiterkörper 2 mit einer Halbleiterschichtenfolge bereitgestellt, der auf einem Aufwachssubstrat 25 abgeschieden ist. Die Halbleiterschichtenfolge wird bevorzugt epitaktisch, beispielsweise mittels MBE, MOVPE oder LPE abgeschieden. Das Aufwachssubstrat kann beispielsweise GaAs, SiC, GaAsP oder Saphir enthalten oder aus einem solchen Material bestehen.

Auf den vorgefertigten Halbleiterkörper 2 wird eine Kontaktschicht 61 aufgebracht, vorzugsweise abgeschieden, beispielsweise mittels Sputterns oder Aufdampfens. Eine dem Halbleiterkörper abgewandte, und nach der Befestigung dem Träger zugewandte, Oberfläche 63 der Kontaktschicht 61 bildet eine Befestigungsfläche 29, die zur Befestigung des Halbleiterkörpers 2 an dem Träger 3 vorgesehen ist.

Nachfolgend wird eine Verbindungsschicht 4 zwischen der Befestigungsfläche 29 und der Montagefläche 39 ausgebildet. Dies ist in Figur 8B dargestellt. Bevorzugt ist die Verbindungsschicht mittels einer Formmasse, etwa einer Klebemasse gebildet. Die Formmasse kann auf der Montagefläche 39 oder auf der Befestigungsfläche 29 bereitgestellt werden.

Ein fertig gestellter Halbleiterchip ist in Figur 8C gezeigt. Bei der Fertigstellung wird zunächst das Aufwachssubstrat 25 entfernt. Dies kann beispielsweise mittels Schleifens, Ätzens oder mittels eines Lasertrennverfahrens erfolgen.

Nachfolgend wird die Kontaktschicht 61 freigelegt. Hierfür wird der Halbleiterkörper 2 bereichsweise entfernt, vorzugsweise mittels Ätzens. Für eine Kontaktierung des Halbleiterchips seitens der dem Träger abgewandten Seite des aktiven Bereichs 21 kann optional auf dem Halbleiterkörper eine weitere Kontaktschicht 62 aufgebracht, vorzugsweise abgeschieden, beispielsweise mittels Sputterns oder Aufdampfens, werden. Auf der Kontaktschicht 61 und der weiteren Kontaktschicht 62 werden ein Kontakt 65 beziehungsweise ein weiterer Kontakt 66 bereitgestellt, wobei der Kontakt 61 in dem freigelegten Bereich der Kontaktschicht auf dieser abgeschieden wird. Über die Kontakte 65 und 66 kann der Halbleiterkörper 2 elektrisch angeschlossen werden.
In einer alternativen Variante kann der Halbleiterkörper auch auf einem Hilfsträger bereitgestellt werden. Dieser kann der mechanischen Stabilisierung der Halbleiterschichtenfolge dienen. Das Aufwachssubstrat 25 ist in diesem Fall hierfür nicht erforderlich. So kann das Aufwachssubstrat 25 bereits vor dem Befestigen des Halbleiterkörpers 2 an dem Träger 3 zumindest bereichsweise abgelöst oder gedünnt werden.
Weiterhin kann bei dieser alternativen Variante die Fläche des Halbleiterkörpers 2 dem Träger 3 zugewandt sein, die ursprünglich dem Aufwachssubstrat 25 zugewandt war. Auch in diesem Fall ist das Aufwachssubstrat bevorzugt zumindest bereichsweise gedünnt oder entfernt.
Die Erfindung ist nicht durch die Beschreibung anhand der Ausführungsbeispiele beschränkt.

## Patentansprüche

1. Halbleiterchip (1) mit einem Träger (3) und mit einem Halbleiterkörper (2), der eine Halbleiterschichtenfolge mit einem zur Erzeugung von Strahlung vorgesehenen aktiven Bereich (21) umfasst, wobei
- der Träger (3) eine dem Halbleiterkörper (2) zugewandte erste Trägerfläche (31) und einem vom Halbleiterkörper (2) abgewandte zweite Trägerfläche (32) aufweist,
- zwischen der zweiten Trägerfläche (32) und dem aktiven Bereich (21) eine Mehrzahl von reflektierenden oder streuenden Elementen (40, 7) ausgebildet ist,
- der Halbleiterkörper (2) mittels einer Verbindungsschicht (4), zwischen einer Befestigungsfläche (29) auf dem Halbleiterkörper (2) und einer Montagefläche (39) auf dem Träger (3), stoffschlüssig an dem Träger (3) befestigt ist,
- zwischen dem Halbleiterkörper (2) und der Verbindungsschicht (4) eine für im aktiven Bereich (21) erzeugte Strahlung durchlässige Kontaktschicht (61) ausgebildet ist, wobei die Kontaktschicht (61) im Betrieb zur Einprägung eines Betriebsstroms vorgesehen ist, und
- die Wellenführung durch die reflektierenden oder streuenden Elemente gestört ist, **dadurch gekennzeichnet, dass**
- der Brechungsindex der Kontaktschicht (61) an den Brechungsindex des Halbleiterkörpers (2) angepasst ist.

2. Halbleiterchip nach dem vorhergehenden Anspruch,
bei dem die Verbindungsschicht (4) derart ausgebildet ist, dass eine Wellenführung der im Betrieb des Halbleiterchips (1) im aktiven Bereich (21) erzeugten Strahlung innerhalb der Verbindungsschicht (4) gestört ist.

3. Halbleiterchip nach einem der vorhergehenden Ansprüche,
bei dem die Mehrzahl von reflektierenden oder streuenden Elementen mittels Partikeln (40), die in der Verbindungsschicht (4) ausgebildet sind, gebildet ist.

4. Halbleiterchip nach einem der vorhergehenden Ansprüche,
bei dem die Mehrzahl von reflektierenden oder streuenden Elementen mittels einer zumindest bereichsweise eine Oberflächenstruktur aufweisenden Grenzfläche (7) gebildet ist.

5. Halbleiterchip nach Anspruch 4,
bei dem die Oberflächenstruktur der Grenzfläche (7) mittels einer strukturierten Oberfläche (8) gebildet ist.

6. Halbleiterchip nach Anspruch 5,
bei dem die Grenzfläche (7) mit der Oberflächenstruktur eine dem aktiven Bereich zugewandte Fläche (50) einer zwischen dem Halbleiterkörper und dem Träger (3) angeordneten Spiegelschicht (5) ist und die Oberflächenstruktur der Grenzfläche (7) der Struktur der strukturierten Oberfläche (8) folgt.

7. Halbleiterchip nach Anspruch 5 oder 6,
bei dem die strukturierte Oberfläche Strukturelemente (80) aufweist, die unregelmäßig angeordnet sind.

8. Halbleiterchip nach Anspruch 5 oder 6,
bei dem die strukturierte Oberfläche Strukturelemente (80) aufweist, die periodisch angeordnet sind.

9. Halbleiterchip nach einem der vorhergehenden Ansprüche,
bei dem die Verbindungsschicht (4) eine Klebeschicht ist, die für im aktiven Bereich (21) erzeugte Strahlung durchlässig ausgebildet ist.

10. Halbleiterchip nach einem der vorhergehenden Ansprüche,
bei dem die Verbindungsschicht (4) elektrisch isolierend ausgebildet ist.

11. Halbleiterchip nach einem der vorhergehenden Ansprüche, der als Dünnfilm-Halbleiterchip ausgebildet ist.

12. Verfahren zur Herstellung eines Halbleiterchips (1) mit einem Träger (3) und einem Halbleiterkörper (2), der eine Halbleiterschichtenfolge mit einem zur Erzeugung von Strahlung vorgesehenen aktiven Bereich (21) umfasst, mit den Schritten:
a) Bereitstellen des Halbleiterkörpers (2) mit der Halbleiterschichtenfolge, wobei auf dem Halbleiterkörper (2) eine zur Befestigung des Halbleiterkörpers vorgesehene Befestigungsfläche (29) angeboten wird;
b) Bereitstellen des Trägers (3), wobei auf dem Träger (3) eine für die Befestigung des Halbleiterkörpers (2) vorgesehene Montagefläche (39) angeboten wird;
c) Ausbilden einer Verbindungsschicht (4) und einer für im aktiven Bereich erzeugte Strahlung durchlässigen Kontaktschicht (61) zwischen der Befestigungsfläche (29) und der Montagefläche (39) zur stoffschlüssigen Befestigung des Halbleiterkörpers (2) an dem Träger (3), wobei der Brechungsindex der Kontaktschicht (61) an den Brechungsindex des Halbleiterkörpers (2) angepasst ist, die Kontaktschicht (61) zwischen dem Halbleiterkörper (2) und der Verbindungsschicht (4) angeordnet ist und die Kontaktschicht (61) im Betrieb zur Einprägung eines Betriebsstroms vorgesehen ist;
d) Fertigstellen des Halbleiterchips (1);
wobei zwischen der zweiten Trägerfläche (32) und dem aktiven Bereich (21) eine Mehrzahl von reflektierenden oder streuenden Elementen (40, 7) ausgebildet ist, wobei die Wellenführung durch die reflektierenden oder streuenden Elemente (40, 7) gestört ist.

13. Verfahren nach Anspruch 12,
bei dem nach Schritt c) ein Aufwachssubstrat (25), auf dem die Halbleiterschichtenfolge in Schritt a) bereitgestellt wird, für die Halbleiterschichtenfolge zumindest bereichsweise entfernt oder gedünnt wird und
bei dem die Verbindungsschicht(4) mittels eines Verbindungsmittels hergestellt wird, in dem Partikel (40) ausgebildet sind.

14. Verfahren nach Anspruch 12,
bei dem vor Schritt c) die Montagefläche (39) als eine eine Oberflächenstruktur aufweisende Grenzfläche (7) ausgebildet wird, wobei die Oberflächenstruktur der Grenzfläche mittels einer strukturierten Oberfläche (8) gebildet wird, deren Struktur mittels Nano-Imprint-Lithographie hergestellt wird.

## Claims

1. Semiconductor chip (1) with a carrier (3) and with a semiconductor body (2) comprising a semiconductor layer sequence with an active region (21) provided for generating radiation,
- the carrier (3) having a first carrier face (31) facing the semiconductor body (2) and a second carrier face (32) remote from the semiconductor body (2),
- a plurality of reflective or scattering elements (40, 7) being formed between the second carrier face (32) and the active region (21),
- the semiconductor body (2) being attached in integrally bonded manner to the carrier (3) by means of a bonding layer (4) between an attachment surface (29) on the semiconductor body (2) and a mounting surface (39) on the carrier (3),
- a contact layer (61) transmissive for radiation generated in the active region (21) being formed between the semiconductor body (2) and the bonding layer (4), the contact layer (61) being provided for impressing an operating current when in operation, and
- wave guidance being disrupted by the reflective or scattering elements, **characterized in that**
- the refractive index of the contact layer (61) is adapted to the refractive index of the semiconductor body (2).

2. Semiconductor chip according to the preceding claim,
in which the bonding layer (4) is configured such that wave guidance of the radiation generated in the active region (21) when the semiconductor chip (1) is in operation is disrupted within the bonding layer (4).

3. Semiconductor chip according to one of the preceding claims,
in which the plurality of reflective or scattering elements is formed by means of particles (40) formed in the bonding layer (4).

4. Semiconductor chip according to one of the preceding claims,
in which the plurality of reflective or scattering elements is formed by means of a boundary surface (7) comprising a surface pattern at least in places.

5. Semiconductor chip according to claim 4,
in which the surface pattern of the boundary surface (7) is formed by means of a patterned surface (8).

6. Semiconductor chip according to claim 5,
in which the boundary surface (7) with the surface pattern is a face (50) of a mirror layer (5) arranged between the semiconductor body and the carrier (3), said face (50) facing the active region, and the surface pattern of the boundary surface (7) follows the pattern of the patterned surface (8).

7. Semiconductor chip according to claim 5 or 6,
in which the patterned surface comprises pattern elements (80) which are arranged irregularly.

8. Semiconductor chip according to claim 5 or 6,
in which the patterned surface comprises pattern elements (80) which are arranged periodically.

9. Semiconductor chip according to one of the preceding claims,
in which the bonding layer (4) is an adhesive layer which is configured to be transmissive for radiation generated in the active region (21).

10. Semiconductor chip according to one of the preceding claims,
in which the bonding layer (4) is configured to be electrically insulating.

11. Semiconductor chip according to one of the preceding claims,
which is configured as a thin-film semiconductor chip.

12. Method for producing a semiconductor chip (1) with a carrier (3) and a semiconductor body (2) comprising a semiconductor layer sequence with an active region (21) provided for generating radiation, having the steps of:
a) providing the semiconductor body (2) with the semiconductor layer sequence, wherein the semiconductor body (2) offers an attachment surface (29) provided for attachment of the semiconductor body;
b) providing the carrier (3), wherein the carrier (3) offers a mounting surface (39) provided for attachment of the semiconductor body (2);
c) forming a bonding layer (4) and a contact layer (61) transmissive for radiation generated in the active region between the attachment surface (29) and the mounting surface (39) for integrally bonded attachment of the semiconductor body (2) to the carrier (3), wherein the refractive index of the contact layer (61) is adapted to the refractive index of the semiconductor body (2), the contact layer (61) is arranged between the semiconductor body (2) and the bonding layer (4) and the contact layer (61) is provided for impressing an operating current when in operation;
d) finishing the semiconductor chip (1);
wherein a plurality of reflective or scattering elements (40, 7) is formed between the second carrier face (32) and the active region (21), wherein wave guidance is disrupted by the reflective or scattering elements (40, 7).

13. Method according to claim 12,
in which after step c) a growth substrate (25), on which the semiconductor layer sequence is provided in step a), is removed or thinned at least in places for the semiconductor layer sequence and in which the bonding layer (4) is produced by means of a bonding agent in which particles (40) are formed.

14. Method according to claim 12,
in which prior to step c) the mounting surface (39) is configured as a boundary surface (7) comprising a surface pattern, wherein the surface pattern of the boundary surface is formed by means of a patterned surface (8), the pattern of which is produced by means of nanoimprint lithography.

## Revendications

1. Puce semi-conductrice (1) comprenant un support (3) et un corps semi-conducteur (2) doté d'une succession de couches semi-conductrices présentant une zone active (21) prévue pour générer un rayonnement, sur laquelle
- le support (3) présente une première surface de support (31) tournée vers le corps semi-conducteur (2) et une seconde surface de support (32) détourné du corps semi-conducteur (2),
- une pluralité d'éléments réfléchissants ou diffusants (40, 7) est formée entre la seconde surface de support (32) et la zone active (21),
- le corps semi-conducteur (2) est relié par adhérence au support (3) au moyen d'une couche d'interconnexion (4) entre une surface de fixation (29) sur le corps semi-conducteur (2) et une surface de montage (39) sur le support (3),
- une couche de contact (61) perméable au rayonnement généré dans la zone active (21) est formée entre le corps semi-conducteur (2) et la couche d'interconnexion (4), la couche de contact (61) étant prévue pour l'application d'un courant de fonctionnement lors de l'opération,
et
- le guidage d'ondes est perturbé par les éléments réfléchissants ou diffusants, **caractérisé en ce que**
- l'indice de réfraction de la couche de contact (61) est adapté à l'indice de réfraction du corps semi-conducteur (2) .

2. Puce semi-conductrice selon la revendication précédente,
dans laquelle la couche d'interconnexion (4) est formée de telle sorte que le guidage des ondes du rayonnement généré dans la zone active (21) durant le fonctionnement de la puce semi-conductrice (1) est perturbé à l'intérieur de la couche d'interconnexion (4).

3. Puce semi-conductrice selon l'une des revendications précédentes,
dans laquelle la pluralité d'éléments réfléchissants ou diffusants est constituée de particules (40) formées dans la couche d'interconnexion (4).

4. Puce semi-conductrice selon l'une des revendications précédentes,
dans laquelle la pluralité d'éléments réfléchissants ou diffusants est formée par une surface d'une interface (7) présentant une structure de surface au moins dans certaines zones.

5. Puce semi-conductrice selon la revendication 4,
dans laquelle la structure de la surface de l'interface (7) est formée au moyen d'une surface structurée (8).

6. Puce semi-conductrice selon la revendication 5,
dans laquelle l'interface (7) présentant la structure de surface est une surface (50) tournée vers la zone active d'une couche miroir (5) disposée entre le corps semi-conducteur et le support (3) et la structure de surface de l'interface (7) suit la structure de la surface structurée (8).

7. Puce semi-conductrice selon la revendication 5 ou 6,
dans laquelle la surface structurée présente des éléments structuraux (80) disposés de façon irrégulière.

8. Puce semi-conductrice selon la revendication 5 ou 6,
dans laquelle la surface structurée présente des éléments structuraux (80) disposés périodiquement.

9. Puce semi-conductrice selon l'une des revendications précédentes,
dans laquelle la couche d'interconnexion (4) est une couche adhésive conçue pour être perméable au rayonnement généré dans la zone active (21).

10. Puce semi-conductrice selon l'une des revendications précédentes,
dans laquelle la couche d'interconnexion (4) est conçue pour être électro-isolante.

11. Puce semi-conductrice selon l'une des revendications précédentes,
conçue en tant que puce semi-conductrice à couche mince.

12. Procédé de fabrication d'une puce semi-conductrice (1) comprenant un support (3) et un corps semi-conducteur (2) doté d'une succession de couches semi-conductrices présentant une zone active (21) prévue pour générer un rayonnement, comprenant les étapes suivantes :
a) mise à disposition du corps semi-conducteur (2) doté de la succession de couches semi-conductrices, dans lequel une surface de fixation (29) prévue pour la fixation du corps semi-conducteur étant offerte sur le corps semi-conducteur (2) ;
b) mise à disposition du support (3), dans lequel une surface de fixation (39) prévue pour la fixation du corps semi-conducteur (2) étant offerte sur le support (3) ;
c) formation d'une couche d'interconnexion (4) et d'une couche de contact (61) perméable au rayonnement généré dans la zone active entre la surface de fixation (29) et la surface de montage (39) pour relier par adhérence le corps semi-conducteur (2) au support (3), dans lequel l'indice de réfraction de la couche de contact (61) étant adapté à l'indice de réfraction du corps semi-conducteur (2), la couche de contact (61) figurant entre le corps semi-conducteur (2) et la couche d'interconnexion (4), et la couche de contact (61) étant prévue pour l'application d'un courant de fonctionnement lors de l'opération ;
d) finition de la puce semi-conductrice (1) ;
sur laquelle une pluralité d'éléments réfléchissants ou diffusants (40, 7) est formée entre la seconde surface de support (32) et la zone active (21), dans lequel le guidage d'ondes étant perturbé par les éléments réfléchissants ou diffusants (40, 7).

13. Procédé selon la revendication 12,
dans lequel, après l'étape c), un substrat de croissance (25), sur lequel la succession de couches semi-conductrices est fournie à l'étape a), est enlevé ou aminci au moins dans certaines zones pour la succession de couches semi-conductrices et
dans lequel la couche d'interconnexion (4) est produite au moyen d'un agent de liaison dans lequel des particules (40) sont formées.

14. Procédé selon la revendication 12,
dans lequel, avant l'étape c), la surface de montage (39) est conçue en tant qu'interface (7) présentant une structure de surface, dans lequel la structure de la surface de l'interface étant formée par une surface structurée (8) dont la structure est produite au moyen d'une lithographie par nano-impression.
